# EUROPEAN PATENT APPLICATION

(11) **EP 1 137 172 A1**
(43) Date of publication of application: **26.09.2001**
(21) Application number: 00951917.4
(22) Date of filing: 09.08.2000
(51) Int. Cl.: H03G 3/02

(54) **VOLUME ADJUSTER FOR SOUND GENERATING DEVICE**

(30) Priority: 10.08.1999 JP 22665699
(71) Applicant: Matsushita Electric Industrial Co., Ltd., Kadoma-shi, Osaka 571-0050 (JP)
(72) Inventor: INOUE, Masayuki, Yokohama-shi Kanagawa 226-0017 (JP); GOMI, Mika, Shibuya-ku Tokyo 150-0034 (JP); ISHIHARA, Takashi, Yokohama-shi, Kanagawa 224-0054 (JP)
(74) Representative: Grünecker, Kinkeldey, Stockmair & Schwanhäusser Anwaltssozietät
(86) International application number: JP0005336
(87) International publication number: WO0113512

(57) **Abstract**

An object is to provide a sound producer volume control apparatus capable of switching sound volume in a multiple stage and arranged by employing a smaller number of components. A sound producer volume control apparatus is comprised of: a sound producer (13); two resistors (Ra), (Rb) series-connected to a drive circuit of the sound producer (13); two switch units (SW1), (SW2) parallel-connected to the resistors (Ra), (Rb) respectively; a control unit (11) for ON/OFF-controlling the switch units (SW1), (SW2) in response to control signals (C1), (C2); an NPN transistor (Qf) series-connected to the sound producer (13); and a sound producing pattern generator (15) for ON/OFF-controlling the NPN type transistor (Qf) in response to a sound producing pattern signal (f). In this sound producer control units (SW1), (SW2) are ON/OFF-controlled by the control signals (C1), (C2) so as to variably select the resistance values connected to the sound producer (13), so that sound volume of the sound producer (13) is controlled in a stepwise manner.

## Description

### <Technical Field>

The present invention relates to a sound producer volume control apparatus for controlling sound volume of a sound producer (also referred to as a "sounder" and a "ringer") used in a portable telephone, a PHS (personal handyphone system), and a home telephone. More specifically, the present invention is directed to such a sound producer volume control apparatus arranged by a smaller number of hardware constructions and capable of controlling volume of a sound producer in a multiple stage.

### <Technical Background>

As a conventional sound producer volume control apparatus, for example, Japanese Laid-open Patent Application No. Hei-10-161687 discloses "SOUNDER VOLUME CONTROL CIRCUIT." Fig. 13 is a circuit diagram for indicating this conventional sounder volume control apparatus. In this drawing, this conventional sound producer volume control apparatus is constituted by employing a control unit 101, a sound producing pattern signal generator 103, AND gates U11 to U14, NPN type transistors Q11 to Q14, resistors R11 to R14, and a sound producer (sounder) 105. This conventional sound producer volume control apparatus is arranged in such a manner that resistors R11 to R14 used to determine volume of the sound producer 105 are selected by switch-controlling the NPN type transistors Q11 to Q14.

In other words, the four NPN type transistors Q11 to Q14 are selectively driven via a gate circuit in response to control signals C11 and C12 supplied from the control unit 101 realized by employing a CPU and a microprocessor, and also a sound producing pattern signal "f" generated from the sound producing pattern signal generator 103.

The gate circuit is arranged by the four AND gates U11 to U14. The sound producing pattern signal "f" is inputted to Hi-enable terminals of all of these AND gates U11 to U14. Also, the control signal C11 is entered to both Lo-enable terminals of the AND gates U11 and U12, and Hi-enable terminals of the AND gates U13 and U14. Further, the control signal C12 is inputted to Lo-enable terminals of the AND gates U11 and U13, and Hi-enable terminals of the AND gates U12 and U14.

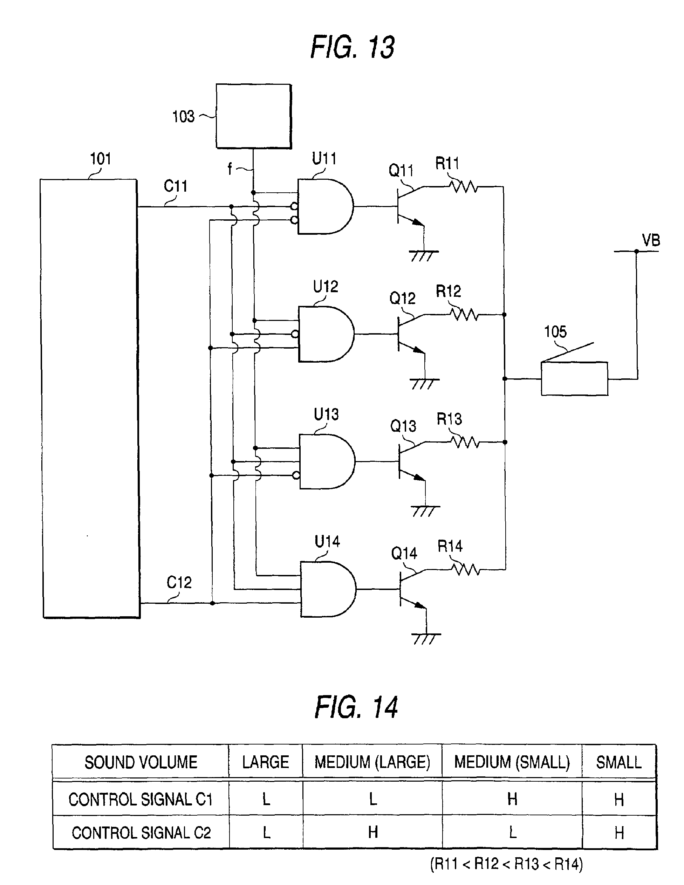

The volume of the sound producer 105 may be switched into four steps, stages such as "high", "medium (large)", "medium (small)", and "low" as indicated in an explanatory diagram of Fig. 14 under control of combining the control signals C11 and C12 with each other. It is so assumed that resistance values of the resistors R11 to R14 for determining the sound volume own a correspondence relationship defined by R11<R12<R13<R14.

First, as indicated in Fig. 14 , when the respective voltage levels of the control signals C11 and C12 are equal to "L" levels, the transistor Q11 is turned ON/OFF in response to the sound producing pattern signal "f", and is driven by a current depending upon the resistor R11 having the minimum resistance value, so that the sound volume of the sound producer 105 becomes "high." Also, when the control signal C11 is equal to an "L" level and the control signal C12 is equal to an "H" level, the transistor Q12 is turned ON/OFF, and is driven by such a current depending upon the resistor R12, so that the sound volume of the sound producer 105 becomes "medium (large)." Also, when the control signal C11 is equal to an "H" level and the control signal C12 is equal to an "L" level, the transistor Q13 is turned ON/OFF, and is driven by such a current depending upon the resistor R13, so that the sound volume of the sound producer 105 becomes "medium (small)." Furthermore, when the respective voltage levels of the control signals C11 and C12 are equal to "H" levels, the transistor Q14 is turned ON/OFF in response to the sound producing pattern signal "f", and is driven by a current depending upon the resistor R14 having the maximum resistance value, so that the sound volume of the sound producer 105 becomes "low."

As previously described, in the conventional sound producer volume control apparatus, the sound volume can be switched in the four stages in response to the control signals C11 and C12 supplied form the control unit 101. Also, since the duty ratio of the sound producing pattern signal "f" is changed, the sound volume of the sound producer 105 may be controlled by the fine mode. For instance, when the duty ratio of the sound producing pattern signal "f" is increased, the sound volume is increased.

However, in the above-explained conventional sound producer volume control apparatus, in order to switch the sound volume in "n" stages, this volume control apparatus must be constructed in such a manner that "n" pieces of the above-described AND gates, transistors, and resistors respectively are necessarily required. A total number of electronic components which constitute such a sound volume control circuit is increased in accordance with an increase in the switching stage number of the sound volume. Thus, in such a case that the sound volume is switched in the multiple stage, the total number of electronic components would be increased, so that the component mounting area and the apparatus size would be increased, which impede reductions (down sizing) and/or weight reductions of the sound volume control apparatus. Also, there is another problem that the reductions of the apparatus cost would be impeded.

Also, in a recent sound producer volume control apparatus, when a sound volume control of a sound producer is carried out, a sound producing pattern signal is formed as a PWM (pulse Width Modulation ) control signal, so that such a volume control may be realized by using a smaller number of control signals. However, when popularized melody-sound volume control operation is carried out, the following problem will occur. That is, in such a case that the sound volume control is performed by way of the PWM control system, the sound volume would be varied in combination with tone/timbre. As a consequence, while the sound volume control of the melody sound is carried out, the sound producer volume control apparatus should be arranged by employing both the PWM control system and the selective control system of the sound volume controlling resistors as used in the above-explained conventional control apparatus. Therefore, such a selective control system of the sound volume controlling resistors is desirably realized by using a smaller amount of hardware structures.

The present invention has been made to solve the above-described conventional problems and also desirable aspects, and therefore, has an object to provide a sound producer volume control apparatus capable of switching sound volume in a multiple stage with employment of a smaller number of electronic components, and moreover, capable of controlling sound volume without changing tone/timbres even when melody sound volume control operation is carried out.

### <Disclosure of the Invention>

To solve the above-explained problem, (1) a sound producer volume control apparatus, according to the present invention, is featured by comprising: a plurality of resistors series-connected to a drive circuit of a sound producer; a plurality of first switching means parallel-connected to the plural resistors respectively; control means for ON/OFF-controlling the first switching means based upon a control signal supplied to the first switching means; second switching means series-connected to the sound producer; and sound producing pattern generating means for ON/OFF-controlling the second switching means based upon a sound producing pattern signal supplied to the second switching means.

(2) In the sound producer volume control apparatus as recited in claim (1), the plurality of resistors are connected between the sound producer and the ground potential; and the plurality of first switching means corresponds to a first semiconductor switch whose operation state is changed into an ON state in the case that the control signal is a binary control signal and a level of the control signal is equal to an "H" level.

(3) In the sound producer volume control apparatus as recited in claim (1), the plurality of resistors are connected between the sound producer and a drive power supply potential; the plurality of first switching means corresponds to a second semiconductor switch whose operation state is changed into an ON state in the case that the control signal is a binary control signal and a level of the control signal is equal to an "L" level; and reverse current blocking means for blocking reverse currents flowing from said second semiconductor switch to the control means respectively is provided in a signal path of the control signal.

(4) In the sound producer volume control apparatus as recited in claim (1), one portion of the plural resistors is connected between the sound producer and the ground potential, and the other portion of the plural resistors is connected between the sound producer and a drive power supply potential; the plurality of first switching means parallel-connected to one portion of the plural resistors correspond to a first semiconductor switch whose operation state is changed into an ON state when the control signal is a binary control signal and the signal level of the control signal is equal to an "H" level; the plurality of first switching means parallel-connected to the other portion of the plural resistors correspond to a second semiconductor switch whose operation state is changed into an ON state when the control signal is a binary control signal and the signal level of the control signal is equal to an "L" level; and reverse current blocking means for blocking reverse currents flowing from the second semiconductor switch to the control means respectively is provided in a signal path of the control signal supplied to the second semiconductor switch.

(5) In the sound producer volume control apparatus as recited in claim (2) or (4), the first semiconductor switch corresponds to an NPN type transistor, or an N-channel type field-effect transistor.

(6) In the sound producer volume control apparatus as recited in claim (3) or (4), the second semiconductor switch corresponds to a PNP type transistor, or a P-channel type field-effect transistor; and the reverse current blocking means corresponds to an NPN type transistor.

(7) In the sound producer volume control apparatus as recited in claim (1), (2), (3), (4), (5), or (6), the sound producing pattern generating means includes comparing means for comparing a preselected signal with a reference voltage, and outputs a PWM control signal as the sound producing pattern signal; and a duty ratio of the PWM control signal is changed in response to the reference voltage.

(8) In the sound producer volume control apparatus as recited in claim (1), (2), (3), (4), (5), (6), or (7), the sound producing pattern generating means AND-gates a signal having a predetermined duty ratio and a PWM control signal whose duty ratio is variable so as to produce the sound producing pattern signal.

In the sound producer volume control apparatus as recited in claim 1 of the present invention, a plurality of first switching means parallel-connected to the plural resistors are ON/OFF-controlled so as to variably select the resistance values connected to the drive circuit of the sound producer in the stepwise mode, so that the sound volume of the sound producer is controlled. Also, the second switching means is ON/OFF-controlled by using the sound producing pattern signal generated from the sound producing pattern signal generating means, so that the sound volume of the sound producer may be controlled in the fine mode. In this case, the sound producing pattern signal is to determine the pattern of the monotone, the pattern of the dual tone, or the pattern of the melody sound. The tone is determined by the frequency of this sound producing pattern signal.

As explained above, the sound volume can be switched in (2^{j}) stages based on the ON/OFF states of (j) pieces of switch units in response to the combined control of (j) pieces of the control signals. As a consequence, in the conventional volume control apparatus, (2^{j}) pieces of AND gates, transistors, and resistors are required. To the contrary, the sound producer volume control apparatus of the present invention can be basically constituted by employing such an arrangement made by (j+1) pieces of transistors and (j) pieces of resistors based upon ON/OFF states of the (j) pieces of switch units in response to the combination controls of (j) pieces of control signals. The reduction in the hardware total amounts of the sound producer volume control apparatus according to the present invention becomes conspicuous in accordance with the total stage number of the sound volume switching operations, as compared with the prior art. In accordance with this sound producer volume control apparatus of the present invention, even in such a case that the sound volume is switched in the multiple stage, while a total number of electronic components is multiple stage, while a total number of electronic components is suppressed, the size of the volume control apparatus can be reduced and can be made in light weight, and also can be manufactured in low cost.

Also, in the sound producer volume control apparatus according to claims (2) and (5), the plural resistors are connected between the sound producer and the ground potential, and the plurality of first switching means may be selected as a first semiconductor switch whose operation state is changed into an ON state in the case that the control signal is a binary control signal and a level of the control signal is equal to an "H" level, for example, an NPN type transistor, or an N-channel type field-effect transistor. As explained above, in such a case that the first semiconductor switch is employed which is changed into the ON state when the control signal is the binary control signal and is equal to the "H" level, the sound volume switching operation may be carried out in the (2^{j}) stages by arranging (j+1) pieces of transistors and (j) pieces of resistors.

Also, in the sound producer volume control apparatus according to claims (3) and (6), the plural resistors are connected between the sound producer and the drive power supply potential, the plurality of first switching means are selected as a second semiconductor switch whose operation state is changed into an ON state in the case that the control signal is a binary control signal and a level of the control signal is equal to an "L" level, for example, a PNP type transistor, or a P-channel type field-effect transistor; and reverse current blocking means (for example, NPN type transistor) for blocking reverse currents flowing from the second semiconductor switch to the control means respectively is provided in a signal path of the control signal. As a result, the reverse current flowing from the second semiconductor switch to the control means is blocked.

In this case, the reverse current blocking means is employed so as to avoid such a condition that the second semiconductor switch is destroyed by the reverse current flowing to the control unit in such a case that while the respective output terminals of the control unit for outputting the control signal are open-collectors, or open-drains, the power supply voltage on the control unit side is lower than the drive power supply voltage. As explained above, in such a case that the second semiconductor switch is employed which is changed into the ON state when the control signal is the binary control signal and is equal to the "L" level, the sound volume switching operation may be carried out in the (2^{j}) stages by arranging (j+1) pieces of transistors and (j) pieces of resistors. Even when the reverse current blocking means is added, (j) pieces of reverse current blocking means (for example, NPN type transistor) are merely required.

Also, in the sound producer volume control apparatus according to claims (4), (5), and (6), one portion of the plural resistors is connected between the sound producer and the ground potential, and the other portion of the plural resistors is connected between the sound producer and a drive power supply potential; the plurality of first switching means parallel-connected to one portion of the plural resistors correspond to a first semiconductor switch whose operation state is changed into an ON state when the control signal is a binary control signal and the signal level of the control signal is equal to an "H" level, for example, an NPN type transistor, or an N-channel type FET; the plurality of first switching means parallel-connected to the other portion of the plural resistors correspond to a second semiconductor switch whose operation state is changed into an ON state when the control signal is a binary control signal and the signal level of the control signal is equal to an "L" level, for example, a PNP type transistor, or a P-channel type FET; and reverse current blocking means (for example, NPN type transistor) for blocking reverse currents flowing from the second semiconductor switch to the control means respectively is provided in a signal path of the control signal supplied to the second semiconductor switch.

As explained above, in such a case that both the first semiconductor switch and the second semiconductor switch are combined with each other, while the first semiconductor switch is changed into the ON state when the control signal is the binary control signal and is equal to the "H" level, and the second semiconductor switch is changed into the ON state when the control signal is the binary control signal and is equal to the "L" level, the sound volume switching operation may be basically carried out in the (2^{j}) stage by arranging (j+1) pieces of transistors and the (j) pieces of resistors. Even when the reverse current blocking means is added, plural numbers of reverse current blocking means (for example, NPN type transistors) equal to these second semiconductor switches are merely required.

Also, in the sound producer volume control apparatus according to claim (7), in the sound producing pattern generating means, the comparing means compares the predetermined signal with the reference voltage, and outputs the PWM control signal whose duty ratio is varied in response to the reference voltage as the sound producing pattern signal. As explained above, while the sound producing pattern signal is used as the PWM control signal, the sound volume control operation is carried out in the coarse manner by employing, for example, the selective control system capable of selecting the resistance values connected to the drive circuit of the sound producer in the step wise mode. Also, the sound volume control operation is carried out in the fine mode by employing the PWM control system with employment of the PWM control signal. As a result, the hardware total amounts can be reduced, and also such a difficulty as the tone change caused by the sound volume control of the melody sound can be suppressed.

Further, in the sound producer volume control apparatus according to claim (8), the sound producing pattern generating means AND-gates a signal having a predetermined duty ratio and a PWM control signal whose duty ratio is variable so as to produce the sound producing pattern signal. As a result, the sound volume can be controlled in the fine mode by the PWM control system.

### <Brief Description of the Drawings>

Fig. 1 is a circuit diagram for indicating a sound producer volume control apparatus according to a first embodiment mode of the present invention.

Fig. 2 is an explanatory diagram for explaining a relationship between a condition of a switch unit and sound volume of a sound producer employed in the sound producer volume control apparatus according to the embodiment mode.

Fig. 3 is a circuit diagram for indicating a sound producer volume control apparatus according to a first embodiment of the first embodiment mode.

Fig. 4 is a circuit diagram for showing a sound producer volume control apparatus according to a second embodiment of the first embodiment mode.

Fig. 5 is a circuit diagram for representing a sound procedure volume control apparatus according to a second embodiment mode of the present invention.

Fig. 6 is a circuit diagram for indicating a sound producer volume control apparatus according to a first embodiment of the second embodiment mode.

Fig. 7 is a circuit diagram for showing a sound producer volume control apparatus according to a second embodiment of the second embodiment mode.

Fig. 8 is a circuit diagram for representing a sound procedure volume control apparatus according to a third embodiment mode of the present invention.

Fig. 9 is a circuit diagram for indicating a sound producer volume control apparatus according to a fourth embodiment mode of the present invention.

Fig. 10 is a circuit diagram for showing a sound producer volume control apparatus according to a second embodiment of the fifth embodiment mode of the present invention.

Fig. 11 is a circuit diagram for indicating a sound producer volume control apparatus according to a first embodiment of the fifth embodiment mode.

Fig. 12 is a circuit diagram for showing a sound producer volume control apparatus according to a second embodiment of the fifth embodiment mode.

Fig. 13 is the circuit diagram for representing the conventional sound procedure volume control apparatus.

Fig. 14 is the explanatory diagram for explaining the relationship between the control signals and the sound volume of the sound producer employed in the conventional sound producer volume control apparatus.

It should be understood that reference numeral 11 indicates a control unit, reference numeral 13 shows a sound producer, reference numeral 15 denotes a sound producing pattern signal generator, and reference numeral 17 is a comparator. Also, reference numeral 19 indicates an AND gate, symbols C1 and C2 show control signals, symbol "f" denotes a sound producing pattern signal, symbols SW1 and SW2 represent switch units, symbols Ra and Rb show resistors, symbols Qf, Q3, Q4 represent NPN type transistors, symbols P1 and P2 show P-channel type EFTs (field-effect transistors), symbols P3 and P4 indicate N-channel type FETs (field-effect transistors), and symbols R1 to R6 indicate resistors.

### <Best Mode for Carrying out the Invention>

Now, a detailed description will be made of [First embodiment mode], (Second embodiment mode], [Third embodiment mode], [Fourth embodiment mode], and [Fifth embodiment mode] in this order with respect to embodiment modes of a sound producer volume control apparatus according to the present invention with reference to drawings. It should also be noted that numeral values indicated in descriptions of the respective embodiment modes are merely exemplified as one design example, and therefore, the sound producer volume control apparatus of the present invention is not limited to such numeral values.

### [First embodiment mode]

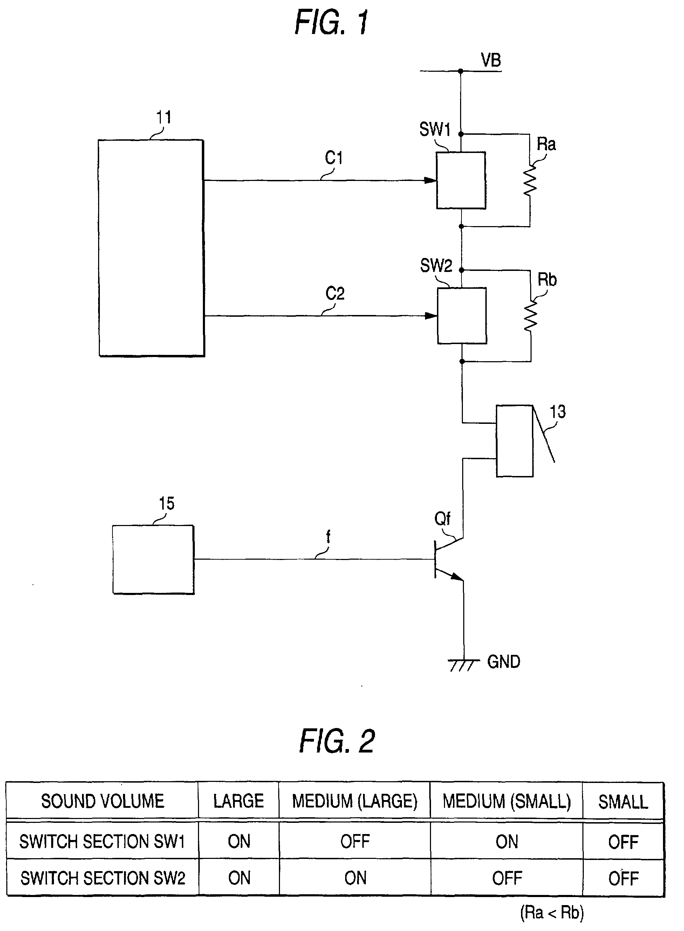

Fig. 1 is a circuit diagram for showing a sound producer volume control apparatus according to a first embodiment mode of the present invention. In this drawing, the sound producer volume control apparatus of this embodiment mode is arranged by employing a sound producer 13; two resistors Ra and Rb, which are connected in series to a drive circuit of the sound producer 13; two switch units (switching means) SW1 and SW2, which are connected in parallel to the respective resistors Ra and Rb; a control unit 11 for ON/OFF-controlling these switch units SW1 and SW2 in response to control signals C1 and C2, which are supplied to the switch units SW1 and SW2, respectively; and an NPN type transistor (second switching means) Qf connected in series to the sound producer 13; and further a sound producing pattern generator 15 for ON/OFF-controlling this NPN type transistor "Qf" in response to a sound producing pattern signal "f" which is supplied to the NPN type transistor Qf.

It should be noted that both a parallel circuit constructed of the resistor Ra and the switch unit SW1, and another parallel circuit constructed of the resistor Rb and the switch unit SW2 are series-connected between a drive power supply VB and the sound producer 13, and the NPN type transistor Qf is connected between the sound producer 13 and the ground potential GND. Also, the circuit arrangement of this embodiment mode is realized by such an assumption that a second semiconductor switch (either PNP type transistor or P-channel type field-effect transistor) is employed as the switch units SW1 and SW2. This second semiconductor switch is changed into an ON state when the control signals C1 and C2 are binary signals and are equal to "L" levels. In this case, in order to necessarily secure such a potential difference which is required to change this second semiconductor switch into the ON state between a power supply (VB)-sided terminal and a control electrode, the resistance value of the resistor (Ra) which is connected close to the power supply (VB) side may be preferably selected to be smaller than that of the resistor (Rb) connected close to the sound producer 13.

In other words, the sound volume of the sound producer 13 is controlled in a stepwise mode in such a manner that the switch unit SW1 and SW2 are ON/OFF-controlled in response to the control signals C1 and C2 issued from the control unit 11 realized by employing a CPU and a microcomputer so as to variably select the resistance values connected to the drive circuit of the sound producer 13 in a stepwise mode. Alternatively, the sound volume of the sound producer 13 may be controlled in a fine mode in response to the sound producing pattern signal "f" generated from the sound producing pattern signal generator 15. In this case, normally, as this sound producing pattern signal "f", such a PWM signal having a duty ratio of approximately 50 % is employed in order to determine a pattern of monotone, a pattern of dual-tone, or a pattern of melody sound. Also, musical scales of melody sound may be selected by varying the frequency of the sound producing pattern signal "f."

As indicated in an explanatory diagram of Fig. 2, the sound volume of the sound producer 13 is switched in the four stages of "high", "medium (large)", "medium (small)", and "low" by ON/OFF states of the switch units SW1 and SW2 in response to a combination control made of the control signals C1 and C2. The following assumption is made in this case. That is, as previously explained, the relationship of Ra<Rb is established in the resistance values of the resistors Ra and Rb used to determine the sound volume, and ON-resistors Rs1 and Rs2 of the switch units SW1 and SW2 are very small, as compared with the resistors Ra and Rb.

First, as indicated in Fig. 2, when both the switch units SW1 and SW2 are under ON-states in response to the control signals C1 and C2, the transistor Qf is turned ON/OFF in response to the sound producing pattern signal "f", and a drive current of the sound producer 13 flows through the ON resistors Rs1 and Rs1 of the switch units SW1 and SW2, the resistance values of which are very small. As a result, a total load becomes substantially equal to zero, and thus, the sound volume of the sound producer 13 becomes maximum "high." Also, when the switch unit SW1 is under OFF-state and also the switch unit SW2 is under ON-state, a drive current of the sound producer 13 flows through the resistor Ra and the ON resistor Rs2 of the switch unit SW2. Since a total load is substantially equal to the resistance value of the resistor Ra (Ra<Rb), the sound volume becomes "medium (large)." Also, when the switch unit SW1 is under ON-state and also the switch unit SW2 is under OFF-state, a drive current of the sound producer 13 flows through the resistor Rb and the ON resistor Rs1 of the switch unit SW1. Since a total load is substantially equal to the resistance value of the resistor Rb, the sound volume becomes "medium (small)." Furthermore, when both the switch units SW1 and SW2 are under OFF-states in response to the control signals C1 and C2, a drive current of the sound producer 13 flows through the resistors Ra and Rb. Since a total load is equal to a summation of the resistance values of the resistors Ra and Rb, the sound volume becomes "low."

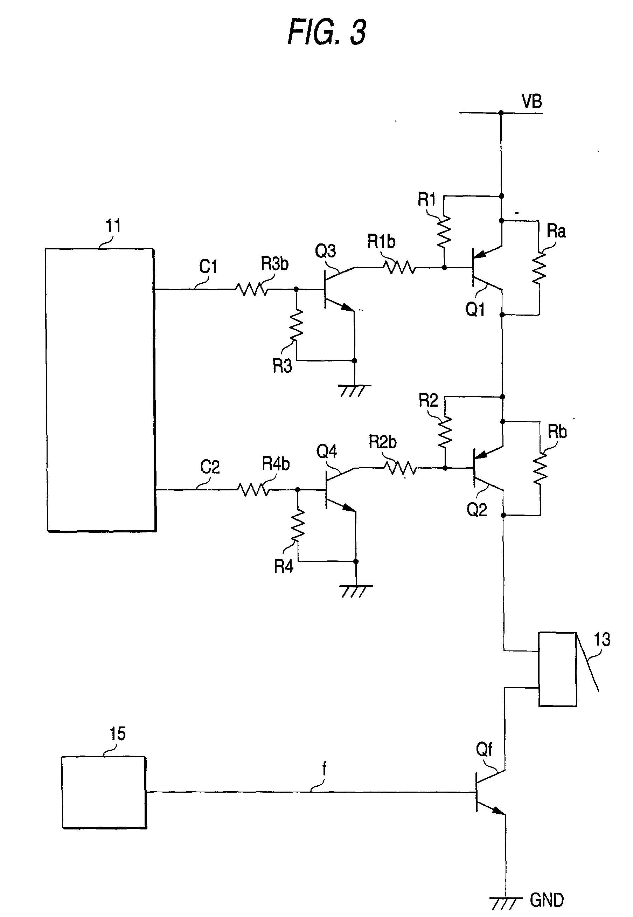

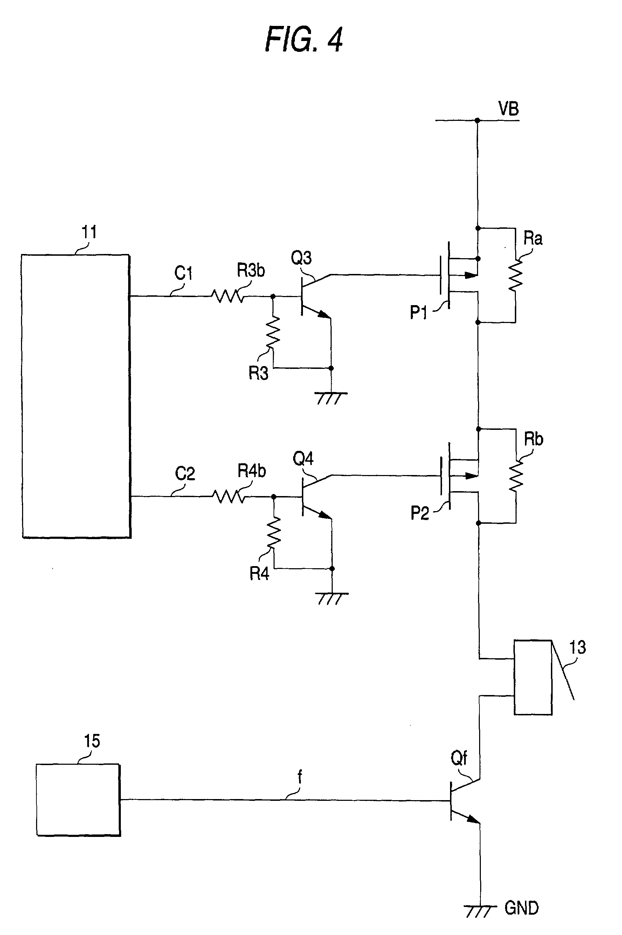

Next, concrete embodiments as to the sound produce volume control apparatus according to this embodiment mode will now be explained more in detail with reference to Fig. 3 and Fig. 4. That is, in a first embodiment (see Fig. 3), PNP type bipolar transistors are used as the switch units SW1 and SW2. In a second embodiment (see Fig. 4), P-channel type FETs (field-effect transistors) are used as the switch units SW1 and SW2.

### (First embodiment)

First, Fig. 3 is a circuit diagram for showing a sound producer volume control apparatus according to a first embodiment of the first embodiment mode. In this drawing, in this embodiment mode, PNP bipolar transistors Q1 and Q2 are used as the switch units SW1 and SW2 of the sound producer volume control apparatus.

Also, in Fig. 3, a resistor R1 and a resistor R2 are connected between bases and emitters of the PNP type transistors Q1 and Q2 in order to secure a potential difference (on the order of 0.7 V). This potential difference is required as a base-to-emitter voltage "VBE" to change these PNP type transistors Q1/Q2 into ON states. Also, a base resistor R1b and a base resistor R2b are connected to bases of the PNP type transistors Q1/Q2, respectively.

Since the PNP type transistors Q1 and Q2 correspond to such switching elements whose operation states are changed into ON states when the control signals C1 and C2 supplied to the base electrodes thereof are equal to "L" levels, there is such a risk that a reverse current may flow through the control unit 11 and thus this control unit 11 may be destroyed in such a case that while the respective output terminals of the control unit 11 which outputs the control signals C1 and C2 are either open collector or open drain, the power supply voltage appeared on the side of the control unit 11 is lower than the power supply voltage of the drive power supply VB. As a consequence, in this embodiment, a reverse current blocking means is employed so as to prevent the reverse current flowing to the control unit 11. In the example shown in Fig. 3, PNP type transistors Q3 and Q4 whose emitters are connected to the ground correspond to reverse current blocking means with respect to the PNP type transistors Q1 and Q2, respectively. Also, resistors R3 and R4 are connected between bases and emitters of these NPN type transistors Q3/Q4, and base resistors R36 and R46 are connected to these NPN type transistors Q3/Q4.

### (Second embodiment)

Next, Fig. 4 is a circuit diagram for showing a sound producer volume control apparatus according to a second embodiment of the first embodiment mode. In this drawing, in this embodiment mode, P-channel type field-effect transistors P1 and P2 are used as the switch units SW1 and SW2 of the (FETs) sound producer volume control apparatus.

Similar to the first embodiment, since P-channel type FETs P1 and P2 correspond to such switching elements whose operation states are changed into ON states when the control signals C1 and C2 supplied to the gate electrodes thereof are equal to "L" levels, there is such a risk that a reverse current may flow through the control unit 11 and thus this control unit 11 may be destroyed in such a case that while the respective output terminals of the control unit 11 which outputs the control signals C1 and C2 are either open collector or open drain, the power supply voltage appeared on the side of the control unit 11 is lower than the power supply voltage of the drive power supply VB. As a consequence, in this embodiment, a reverse current blocking means is employed so as to prevent the reverse current flowing to the control unit 11. In the example shown in Fig. 4, NPN type transistors Q3 and Q4 whose emitters are connected to the ground correspond to reverse current blocking means with respect to the PNP type transistors Q1 and Q2, respectively. Also, resistors R3 and R4 are connected between bases and emitters of these NPN type transistors Q3/Q4, and base resistors R36 and R46 are connected to these NPN type transistors Q3/Q4.

As previously explained, in accordance with the sound producer volume control apparatus of the first embodiment mode (including first embodiment and second embodiment), the sound volume can be switched in the four stages in correspondence with the states (ON/OFF states) of the switch units SW1 and SW2 in response to the combined control of the control signals C1/C2.

Also, the sound volume and the tone of the sounds (mono-tone, dual tone, melody sound) produced by the sound producer 13 may be controlled in the fine mode by changing the duty ratio and the frequency of this sound producing pattern signal "f." For example, when the duty ratio of the sound producing pattern signal "f" is increased, the sound volume may be increased. Also, while the sound producing pattern signal "f" is formed as the PWM control signal, the sound volume control operation is carried out in the coarse mode by mainly executing the selection control system of the sound volume controlling resistors (Ra, Rb), and also the sound volume control operation is carried out in the fine mode by executing the PWM control system. As a result, such a difficulty that the tone is changed while the sound volume of melody sound is controlled can be suppressed.

It should be noted in this first embodiment mode that the volume control apparatus is arranged by switching the sound volume in the four stages. Alternatively, the sound volume may be easily switched in a multiple stage. For instance, when the sound volume is switched in eight stages, three sets of the parallel circuits constituted by the switch units and the resistors are series-connected between the sound producer 13 and the drive power supply VB, and the three switch units are ON/OFF-controlled in response to three sets of control signals.

Also, when the hardware total amount of this sound producer volume control apparatus is compared with that of the conventional volume control apparatus (see Fig. 13), in order to switch the sound volume in "n (= 2^{k})" stages, "n" pieces of AND gates, and "n" pieces of resistors are required in the prior art. However, in accordance with this embodiment mode, the sound producer volume control apparatus may be constituted by using (K+1) pieces of transistors and (K) pieces of resistors. Even when the reverse current blocking means is added, "K" pieces of transistors are furthermore required. A difference in the hardware total amounts becomes conspicuous in accordance with the total stage number of the sound volume switching operations. In accordance with this embodiment mode, even in such a case that the sound volume is switched in the multiple stage, while a total number of electronic components is suppressed, the size of the volume control apparatus can be reduced and can be made in light weight, and also can be manufactured in low cost.

### [Second embodiment mode]

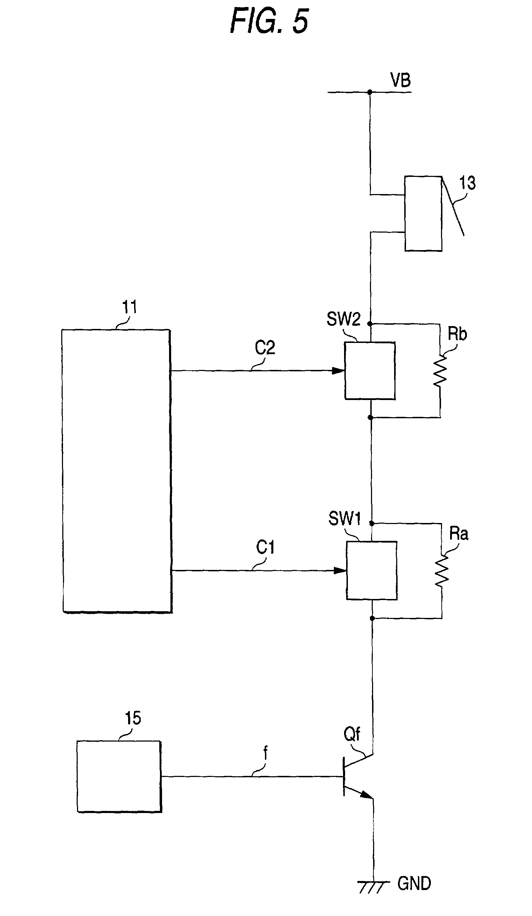

Fig. 5 is a circuit diagram for showing a sound producer volume control apparatus according to a second embodiment mode of the present invention. In this drawing, similar to the first embodiment mode, the sound producer volume control apparatus of this embodiment mode is arranged by employing a sound producer 13; two resistors Ra and Rb, which are connected in series to a drive circuit of the sound producer 13; two switch units SW1 and SW2, which are connected in parallel to the respective resistors Ra and Rb; a control unit 11 for ON/OFF-controlling these switch units SW1 and SW2 in response to control signals C1 and C2; an NPN type transistor Qf and further a sound producing pattern generator 15 for ON/OFF-controlling this NPN type transistor "Qf" in response to a sound producing pattern signal "f."

It should be noted that both a parallel circuit constructed of the resistor Rb and the switch unit SW2, and another parallel circuit constructed of the resistor Ra and the switch unit SW1, and the NPN type transistor Qf are series-connected between the ground potential GND and the sound producer 13. Also, the circuit arrangement of this embodiment mode is realized by such an assumption that a first semiconductor switch (either NPN type transistor or N-channel type field-effect transistor) is employed as the switch units SW1 and SW2. This first semiconductor switch is changed into an ON state when the control signals C1 and C2 are binary signals and are equal to "H" levels. In this case, in order to necessarily secure such a potential difference which is required to change this first semiconductor switch into the ON state between a ground potential (GND)-sided terminal and a control electrode, the resistance value of the resistor (Ra) which is connected close to the ground potential (GND) side may be preferably selected to be smaller than that of the resistor (Rb) connected close to the sound producer 13.

In other words, also in this embodiment mode, the sound volume of the sound producer 13 is controlled in a stepwise mode in such a manner that the switch unit SW1 and SW2 are ON/OFF-controlled in response to the control signals C1 and C2 issued from the control unit 11 so as to variably select the resistance values connected to the drive circuit of the sound producer 13 in a stepwise mode. Alternatively, the sound volume of the sound producer 13 may be controlled in a fine mode in response to the sound producing pattern signal "f" generated from the sound producing pattern signal generator 15. In this case, normally, as this sound producing pattern signal "f", such a PWM signal having a duty ratio of approximately 50 % is employed in order to determine a pattern of monotone, a pattern of dual-tone, or a pattern of melody sound. Also, musical scales of melody sound may be selected by varying the frequency of the sound producing pattern signal "f."

As indicated in an explanatory diagram of Fig. 2, also in this embodiment mode, the sound volume of the sound producer 13 is switched in the four stages of "high", "medium (large)", "medium (small)", and "low" by ON/OFF states of the switch units SW1 and SW2 in response to a combination control made of the control signals C1 and C2. The following assumption is made in this case. That is, as previously explained, the relationship of Ra<Rb is established in the resistance values of the resistors Ra and Rb used to determine the sound volume, and ON-resistors Rs1 and Rs2 of the switch units SW1 and SW2 are very small, as compared with the resistors Ra and Rb. It should be noted that since the selective control of the resistors by the ON/OFF states of the switch units SW1 and SW2 is carried out in a similar manner to that of the first embodiment mode, descriptions thereof are omitted.

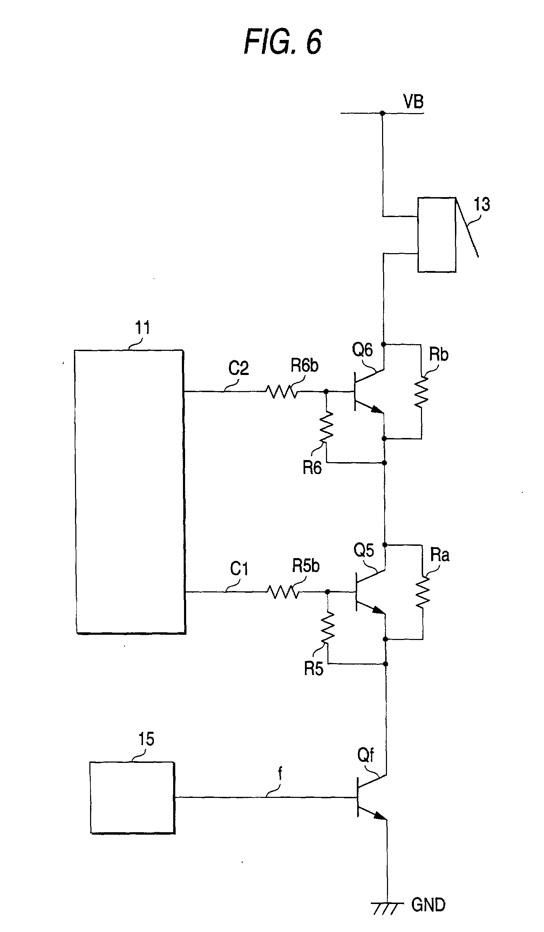

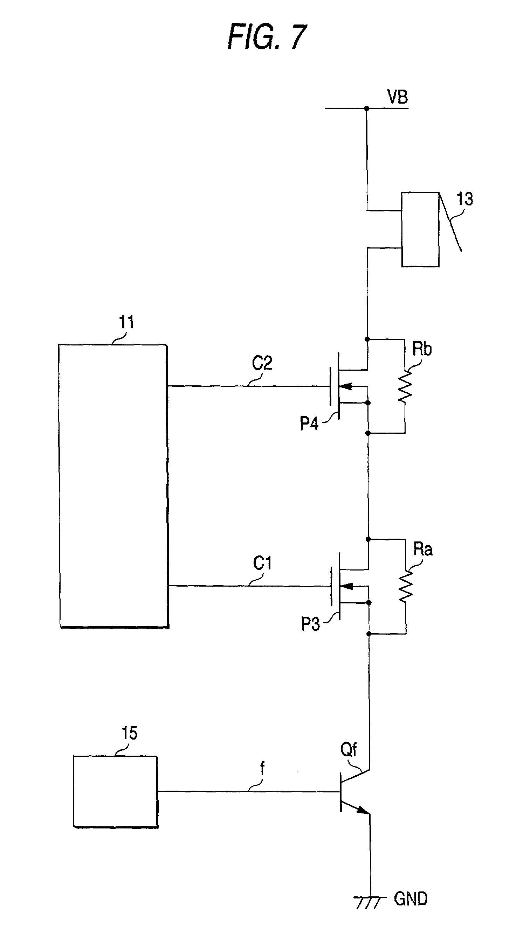

Next, concrete embodiments as to the sound produce volume control apparatus according to this embodiment mode will now be explained more in detail with reference to Fig. 6 and Fig. 7. That is, in a first embodiment (see Fig. 6), NPN type bipolar transistors are used as the switch units SW1 and SW2. In a second embodiment (see Fig. 7), N-channel type FETs (field-effect transistors) are used as the switch units SW1 and SW2.

### (First embodiment)

First, Fig. 6 is a circuit diagram for showing a sound producer volume control apparatus according to a first embodiment of the second embodiment mode. In this drawing, in this embodiment mode, NPN bipolar transistors Q5 and Q6 are used as the switch units SW1 and SW2 of the sound producer volume control apparatus.

Also, in Fig. 6, a resistor R5 and a resistor R6 are connected between bases and emitters of the NPN type transistors Q5 and Q6 in order to secure a potential difference (on the order of 0.7 V). This potential difference is required as a base-to-emitter voltage "VBE" to change these NPN type transistors Q5/Q6 into ON states. Also, a base resistor R5b and a base resistor R5b are connected to bases of the NPN type transistors Q5/Q6, respectively.

### (Second embodiment)

Next, Fig. 7 is a circuit diagram for showing a sound producer volume control apparatus according to a second embodiment of the second embodiment mode. In this drawing, in this embodiment mode, N-channel type field-effect transistors (FETs) P3 and P4 are used as the switch units SW1 and SW2 of the sound producer volume control apparatus.

As previously explained, in accordance with the second producer volume control apparatus of the second embodiment mode (including first embodiment and second embodiment), the sound volume can be switched in the four stages in correspondence with the states (ON/OFF states) of the switch units SW1 and SW2 in response to the combined control of the control signals C1/C2. Also, the sound volume and the tone of the sounds (mono-tone, dual tone, melody sound) produced by the sound producer 13 may be controlled in the fine mode by changing the duty ratio and the frequency of this sound producing pattern signal "f." For example, when the duty ratio of the sound producing pattern signal "f" is increased, the sound volume may be increased. Also, while the sound producing pattern signal "f" is formed as the PWM control signal, the sound volume control operation is carried out in the coarse mode by mainly executing the selection control system of the sound volume controlling resistors (Ra, Rb), and also the sound volume control operation is carried out in the fine mode by executing the PWM control system. As a result, such a difficulty that the tone is changed while the sound volume of melody sound is controlled can be suppressed.

It should be noted in this second embodiment mode that the volume control apparatus is arranged by switching the sound volume in the four stages. Alternatively, the sound volume may be easily switched in a multiple stage. For instance, when the sound volume is switched in eight stages, three sets of the parallel circuits constituted by the switch units and the resistors are series-connected between the sound producer 13 and the ground potential GND, and the three switch units are ON/OFF-controlled in response to three sets of control signals. Also, when the hardware total amount of this sound producer volume control apparatus is compared with that of the conventional volume control apparatus (see Fig. 13), in order to switch the sound volume in "n (= 2^{k})" stages, "n" pieces of AND gates, and "n" pieces of resistors are required in the prior art. However, in accordance with this embodiment mode, the sound producer volume control apparatus may be constituted by using (K+1) pieces of transistors and (K) pieces of resistors. A difference in the hardware total amounts becomes conspicuous in accordance with the total stage number of the sound volume switching operations. In accordance with this embodiment mode, even in such a case that the sound volume is switched in the multiple stage, while a total number of electronic components is suppressed, the size of the volume control apparatus can be reduced and can be made in light weight, and also can be manufactured in low cost.

### [Third embodiment mode]

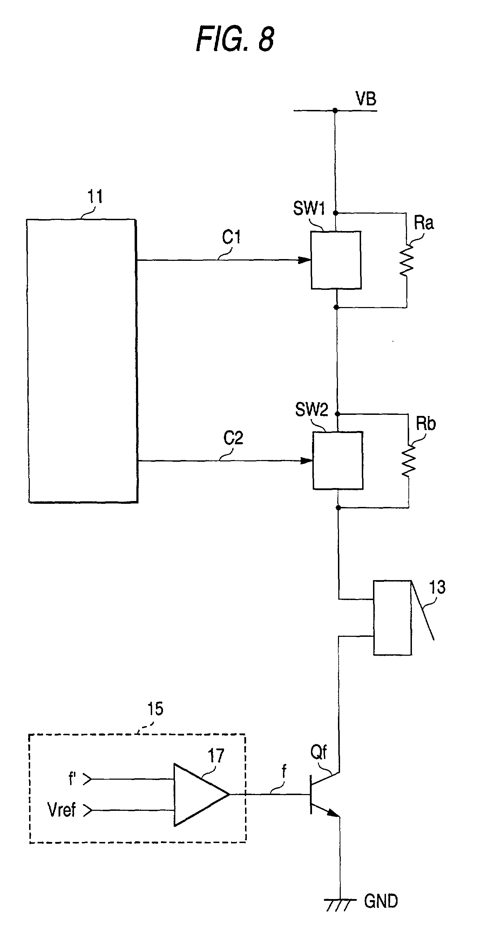

Next, Fig. 8 is a circuit diagram for representing a sound producer volume control apparatus according to a third embodiment mode of the present invention. This embodiment mode employs such an arrangement substantially equivalent to the arrangement (see Fig. 1) of the first embodiment mode, but owns the following different point. That is, a comparator 17 is provided within a sound producing pattern signal generator 15.

In the sound producing pattern signal generator 15, both a signal "f'" indicative of a sound producing pattern and a reference signal voltage "Vref" are entered into the comparator 17. This comparator 17 compares a signal level of the signal "f'" indicative of the sound producing pattern with the reference signal voltage "Vref", and then outputs such a sound producing pattern signal "f." This sound producing pattern signal "f" becomes an "H" level in the case that the signal level of the signal "f' " representative of the sound producing pattern becomes higher than, or equal to the reference signal voltage Vref. In this case, the signal "f'" indicative of the sound producing pattern owns a signal waveform of a sine wave, a signal waveform of a triangular wave, and so on.

In other words, such a PWM control signal is outputted as the sound producing pattern signal "f" from the sound producing pattern generator 15, and a duty ratio of this PWM control signal is varied in response to the reference signal voltage Vref. Similar to either the first embodiment mode or the second embodiment mode, the following sound volume control method may be conceived. For instance, the sound volume control of the sound producer 13 is carried out in the coarse control mode by way of the selective control system for variably selecting the resistance values (Ra, Rb) connected to the sound producer 13 in the step wise manner based upon the ON/OFF states of the switch units SW1 and SW2 in response to the combined control of the control signals C1 and C2. Then, the sound volume of the sound producer 13 is controlled in the fine control mode by variably controlling the duty ratio of the sound producing pattern signal "f" (PWM control signal) in response to level changes in the reference signal voltage Vref. In accordance with this sound volume control method, there is a small change in the frequency components occurred in the sound producer 13 in connection with the change in the duty ratio, so that a change in tone caused by controlling the sound volume of the melody sounds can be suppressed. As a result, the hardware total amounts of the sound producer volume control apparatus can be reduced, and also such a difficulty as the change in tone caused by controlling the sound volume of the melody sounds can be suppressed.

### [Fourth embodiment mode]

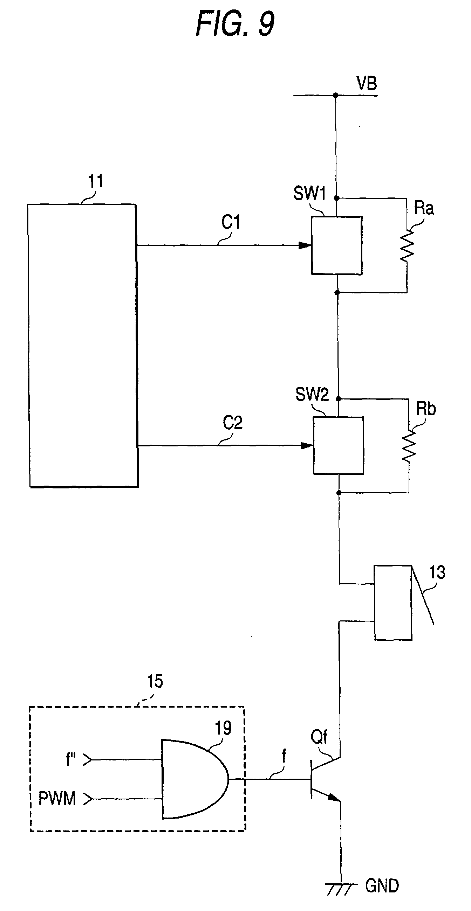

Next, Fig. 9 is a circuit diagram for representing a sound producer volume control apparatus according to a fourth embodiment mode of the present invention. This embodiment mode employs such an arrangement substantially equivalent to the arrangement (see Fig. 1) of the first embodiment mode, but owns the following different point. That is, an AND gate 15 is provided within a sound producing pattern signal generator 15.

In the sound producing pattern signal generator 15, both a signal "f ' ' " indicative of a sound producing pattern and having a preselected duty ratio (50%), and also a PWM control signal "PWM" are entered into the comparator 17. Then, the AND gate 19 AND-gates these two signals, and outputs an AND-gated signal as a sound producing pattern signal "f" which should be supplied to the NPN type transistor Qf.

In other words, since the signal "f ' ' " indicative of the sound producing pattern is AND-gated with the PWM control signal produced by other means, such a PWM control signal whose duty ratio is variable is outputted as the sound producing pattern signal "f" from the sound producing pattern generator 15. Similar to either the first embodiment mode or the second embodiment mode, the following sound volume control method may be conceived. For instance, the sound volume control of the sound producer 13 is carried out in the coarse control mode by way of the selective control system for variably selecting the resistance values (Ra, Rb) connected to the sound producer 13 in the step wise manner based upon the ON/OFF states of the switch units SW1 and SW2 in response to the combined control of the control signals C1 and C2. Then, the sound volume of the sound producer 13 is controlled in the fine control mode by variably controlling the duty ratio of the sound producing pattern signal "f" (PWM control signal). In accordance with this sound volume control method, there is a small change in the frequency components occurred in the sound producer 13 in connection with the change in the duty ratio, so that a change in tone caused by controlling the sound volume of the melody sounds can be suppressed. As a result, the hardware total amounts of the sound producer volume control apparatus can be reduced, and also such a difficulty as the change in tone caused by controlling the sound volume of the melody sounds can be suppressed.

### [Fifth embodiment mode]

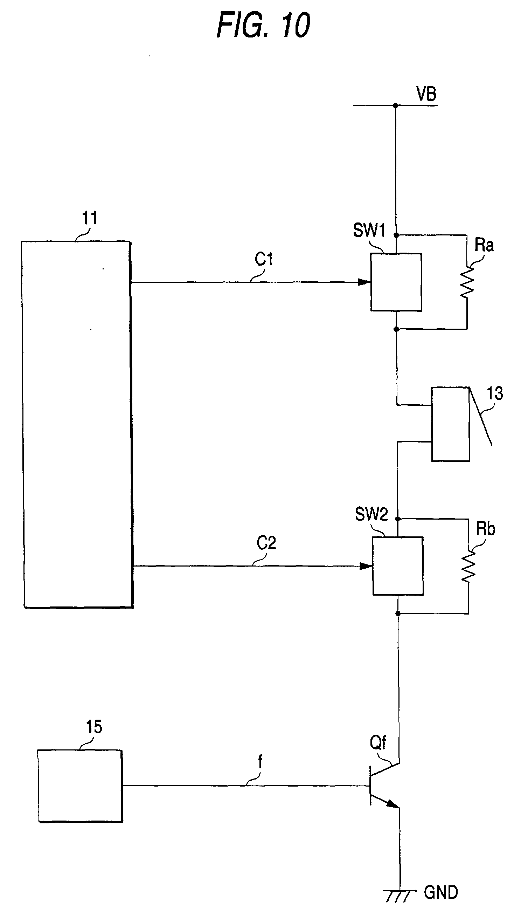

Next, Fig. 10 is a circuit diagram for showing a sound producer volume control apparatus according to a fifth embodiment mode of the present invention. In this drawing, similar to the first embodiment mode, the sound producer volume control apparatus of this embodiment mode is arranged by employing a sound producer 13; two resistors Ra and Rb, which are connected in series to a drive circuit of the sound producer 13; two switch units SW1 and SW2, which are connected in parallel to the respective resistors Ra and Rb; a control unit 11 for ON/OFF-controlling these switch units SW1 and SW2 in response to control signals C1 and C2; an NPN type transistor Qf; and further a sound producing pattern generator 15 for ON/OFF-controlling this NPN type transistor "Qf" in response to a sound producing pattern signal "f."

It should be noted that both a parallel circuit constructed of the resistor Ra and the switch unit SW1 is connected between a drive power supply VB and the sound producer 13, and another parallel circuit constructed of the resistor Rb and the switch unit SW2 and also the NPN type transistor Qf are series-connected between the sound producer 13 and the ground potential GND. Also, the circuit arrangement of this embodiment mode is realized by such an assumption that a second semiconductor switch (either PNP type transistor or P-channel type field-effect transistor) is employed as the switch unit SW1. This second semiconductor switch is changed into an ON state when the control signal C1 is a binary signal and is equal to an "L" level. Also, a first semiconductor switch (either NPN type transistor or N-channel type field-effect transistor) is employed as the switch unit SW2. This first semiconductor switch is changed into an ON state when the control signal C2 is a binary signal and is equal to an "H" level. In this case, the restriction on the relationship between the resistor Ra and the resistor R6, which is desirably employed in either the first embodiment mode or the second embodiment mode, is no longer considered. Therefore, this fifth embodiment mode may be realized even by such a condition of Ra < Rb, and Ra > Rb.

In other words, also in this embodiment mode, the sound volume of the sound producer 13 is controlled in a stepwise mode in such a manner that the switch unit SW1 and SW2 are ON/OFF-controlled in response to the control signals C1 and C2 issued from the control unit 11 so as to variably select the resistance values connected to the drive circuit of the sound producer 13 in a stepwise mode. Alternatively, the sound volume of the sound producer 13 may be controlled in a fine mode in response to the sound producing pattern signal "f" generated from the sound producing pattern signal generator 15. In this case, normally, as this sound producing pattern signal "f", such a PWM signal having a duty ratio of approximately 50 % is employed in order to determine a pattern of monotone, a pattern of dual-tone, or a pattern of melody sound. Also, musical scales of melody sound may be selected by varying the frequency of the sound producing pattern signal "f." It should also be noted that the sound producing pattern signal generator 15 may be realized by employing such an arrangement as explained in the third embodiment mode, or the fourth embodiment mode.

As indicated in an explanatory diagram of Fig. 2, also in this embodiment mode, the sound volume of the sound producer 13 is switched in the four stages of "high", "medium (large)", "medium (small)", and "low" by ON/OFF states of the switch units SW1 and SW2 in response to a combination control made of the control signals C1 and C2. The following condition shown in the explanatory diagram of Fig. 2 is made in this case. That is, as previously explained, the relationship of Ra<Rb is established in the resistance values of the resistors Ra and Rb used to determine the sound volume, and ON-resistors Rs1 and Rs2 of the switch units SW1 and SW2 are very small, as compared with the resistors Ra and Rb. It should also be understood that since the selective controls of the resistors based upon the ON/OFF states of the switch units SW1 and SW2 are similar to those of the first embodiment mode, descriptions thereof are omitted.

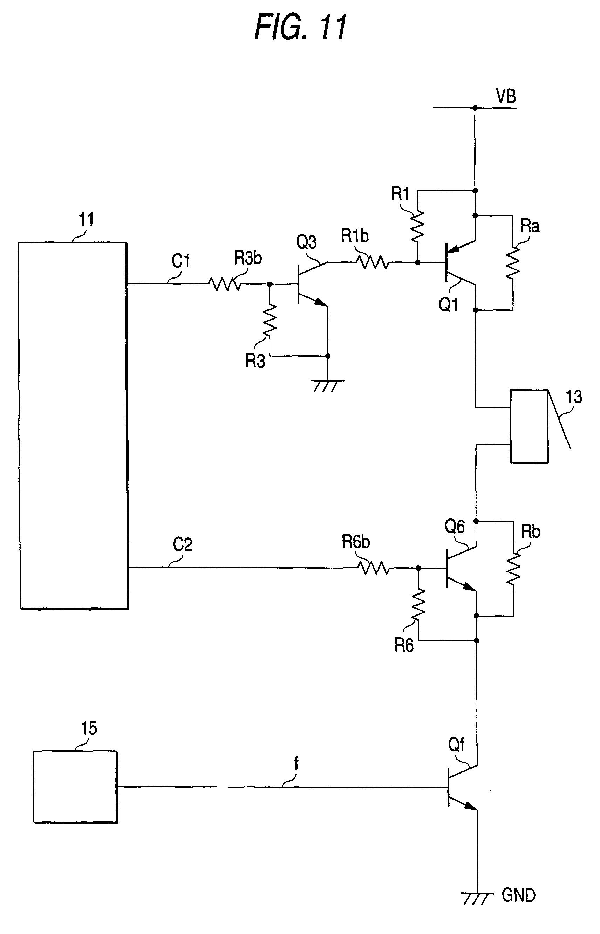

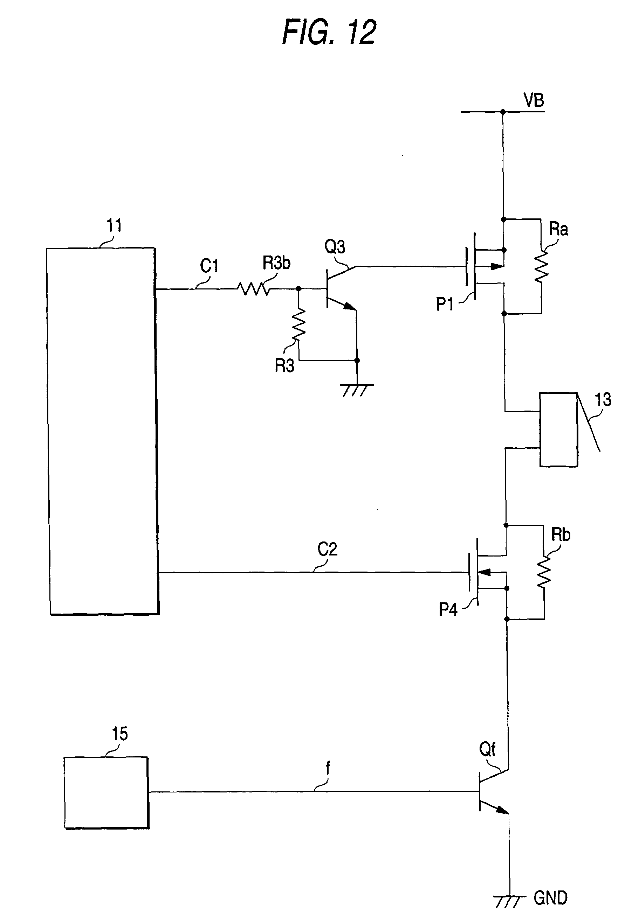

Next, concrete embodiments as to the sound produce volume control apparatus according to this embodiment mode will now be explained more in detail with reference to Fig. 11 and Fig. 12. That is, in a first embodiment (see Fig. 11), a PNP type bipolar transistor and an NPN bipolar transistor are used as the switch units SW1 and SW2. In a second embodiment (see Fig. 12), a P-channel type FET (field-effect transistors) and an N-channel type FET are used as the switch units SW1 and SW2.

### [First embodiment]

First, Fig. 11 is a circuit diagram for showing a sound producer volume control apparatus according to a first embodiment of the fifth embodiment mode. In this drawing, in this embodiment mode, a PNP bipolar transistors Q1, and an NPN bipolar transistor Q6 are used as the switch units SW1 and SW2 of the sound producer volume control apparatus, respectively.

Also, in Fig. 11, a resistor R1 and a resistor R6 are connected between bases and emitters of the PNP type and NPN type transistors Q1 and Q6 in order to secure a potential difference (on the order of 0.7 V). This potential difference is required as a base-to-emitter voltage "VBE" to change these PNP type and NPN type transistors Q1/Q6 into ON states. Also, a base resistor R1b and a base resistor R6b are connected to bases of the PNP type and NPN type transistors Q1/Q6, respectively.

The provision of a reverse current blocking means capable of blocking a reverse current into the control unit 11 within a signal path of the control signal C1 supplied to the PNP type transistor Q1 is similar to that of the first embodiment of the first embodiment mode. In the example shown in Fig. 11, an NPN transistor Q3 whose emitter is grounded is provided as the reverse current blocking means. Also, a base-to-emitter resistor R3 and a base resistor R3b are connected to the NPN type transistor Q3.

### (Second embodiment)

Next, Fig. 12 is a circuit diagram for showing a sound producer volume control apparatus according to a second embodiment of the fourth embodiment mode. In this drawing, in this embodiment mode, a P-channel type field-effect transistors P1 and, an N-channel type field-effect transistor P4 are used as the switch units SW1 and SW2 of the sound producer volume control apparatus, respectively.

The provision of a reverse current blocking means capable of blocking a reverse current into the control unit 11 within a signal path of the control signal C1 supplied to the P-channel type FET P1 is similar to that of the second embodiment of the first embodiment mode. In the example shown in Fig. 12, an NPN transistor Q3 whose emitter is grounded is provided as the reverse current blocking means. Also, a base-to-emitter resistor R3 and a base resistor R3b are connected to the NPN type transistor Q3.

As previously explained, in accordance with the sound producer volume control apparatus of the fourth embodiment mode (including first embodiment and second embodiment), similar to the first and second embodiment modes, the sound volume can be switched in the four stages in correspondence with the states (ON/OFF states) of the switch units SW1 and SW2 in response to the combined control of the control signals C1/C2. Also, the sound volume and the tone of the sounds (mono-tone, dual tone, melody sound) produced by the sound producer 13 may be controlled in the fine mode by changing the duty ratio and the frequency of this sound producing pattern signal "f."

It should be noted in this fourth embodiment mode that the volume control apparatus is arranged by switching the sound volume in a multiple stage. For instance, when the sound volume is switched in eight stages, three sets of the parallel circuits constituted by the switch units and the resistors are series-connected between the sound producer 13 and the ground potential GND, and the three switch units are ON/OFF-controlled in response to three sets of control signals. A reduction in the hardware total amounts of the sound producer volume control apparatus becomes conspicuous in accordance with the total stage number of the sound volume switching operations, as compared with the prior art. In accordance with this embodiment mode, even in such a case that the sound volume is switched in the multiple stage, while a total number of electronic components is suppressed, the size of the volume control apparatus can be reduced and can be made in light weight, and also can be manufactured in low cost.

### <Feasibility in Industrial Field>

As previously explained, in accordance with the sound producer volume control apparatus of the present invention, a plurality of first switching means connected in parallel to a plurality of resistors are ON/OFF-controlled in response to the control signal supplied from the control means, so that the resistance values connected to the drive circuit of the sound producer is variably selected in the step wise manner so as to control the sound volume of the sound producer. Also, in response to the sound producing pattern signal generated from the sound producing pattern generating means, the second switching means is ON/OFF-controlled in order to control the sound volume of the sound producer in the fine mode. As a consequence, the sound volume switching operations in (2^{j}) stages can be basically realized by employing such an arrangement made by (j+1) pieces of transistors and (j) pieces of resistors based upon ON/OFF states of the (j) pieces of switch units in response to the combination controls of (j) pieces of control signals. The reduction in the hardware total amounts of the sound producer volume control apparatus according to the present invention becomes conspicuous in accordance with the total stage number of the sound volume switching operations, as compared with the prior art. In accordance with this sound producer volume control apparatus of the present invention, even in such a case that the sound volume is switched in the multiple stage, while a total number of electronic components is suppressed, the size of the volume control apparatus can be reduced and can be made in light weight, and also can be manufactured in low cost.

Also, while the sound producing pattern signal is used as the PWM control signal, the sound volume control operation is carried out in the coarse manner by employing, for example, the selective control system capable of selecting the resistance values connected to the drive circuit of the sound producer in the step wise mode. Also, the sound volume control operation is carried out in the fine mode by employing the PWM control system with employment of the PWM control signal. As a result, the hardware total amounts can be reduced, and also such a difficulty as the tone change caused by the sound volume control of the melody sound can be suppressed.

## Claims

1. A sound producer volume control apparatus comprising:
a plurality of resistors series-connected to a drive circuit of a sound producer;
a plurality of first switching means parallel-connected to said plural resistors respectively;
control means for ON/OFF-controlling said first switching means based upon a control signal supplied to said first switching means;
second switching means series-connected to said sound producer; and
sound producing pattern generating means for ON/OFF-controlling said second switching means based upon a sound producing pattern signal supplied to said second switching means.

2. A sound producer volume control apparatus as claimed in claim 1 wherein:
said plurality of resistors are connected between said sound producer and the ground potential; and
said plurality of first switching means corresponds to a first semiconductor switch whose operation state is changed into an ON state in the case that said control signal is a binary control signal and a level of said control signal is equal to an "H" level.

3. A sound producer volume control apparatus as claimed in claim 1 wherein:
said plurality of resistors are connected between said sound producer and a drive power supply potential;
said plurality of first switching means corresponds to a second semiconductor switch whose operation state is changed into an ON state in the case that said control signal is a binary control signal and a level of said control signal is equal to an "L" level; and
reverse current blocking means for blocking reverse currents flowing from said second semiconductor switch to said control means respectively is provided in a signal path of said control signal.

4. A sound producer volume control apparatus as claimed in claim 1 wherein:
one portion of said plural resistors is connected between said sound producer and the ground potential, and the other portion of said plural resistors is connected between said sound producer and a drive power supply potential;
said plurality of first switching means parallel-connected to one portion of said plural resistors correspond to a first semiconductor switch whose operation state is changed into an ON state when said control signal is a binary control signal and the signal level of said control signal is equal to an "H" level;
said plurality of first switching means parallel-connected to the other portion of said plural resistors correspond to a second semiconductor switch whose operation state is changed into an ON state when said control signal is a binary control signal and the signal level of said control signal is equal to an "L" level; and
reverse current blocking means for blocking reverse currents flowing from said second semiconductor switch to said control means respectively is provided in a signal path of said control signal supplied to said second semiconductor switch.

5. A sound producer volume control apparatus as claimed in claim 2, or claim 4 wherein:
said first semiconductor switch corresponds to an NPN type transistor, or an N-channel type field-effect transistor.

6. A sound producer volume control apparatus as claimed in claim 3, or claim 4 wherein:
said second semiconductor switch corresponds to a PNP type transistor, or a P-channel type field-effect transistor; and said reverse current blocking means corresponds to an NPN type transistor.

7. A sound producer volume control apparatus as claimed in claim 1, 2, 3, 4, 5, or 6 wherein:
said sound producing pattern generating means includes comparing means for comparing a preselected signal with a reference voltage, and outputs a PWM control signal as said sound producing pattern signal; and
a duty ratio of said PWM control signal is changed in response to said reference voltage.

8. A sound producer volume control apparatus as claimed in claim 1, 2, 3, 4, 5, 6, or 7 wherein:
said sound producing pattern generating means AND-gates a signal having a predetermined duty ratio and a PWM control signal whose duty ratio is variable so as to produce said sound producing pattern signal.
